(19) Europäisches Patentamt
European Patent Office
Office européen des brevets

(11) **EP 2 998 753 B1**

(12) **EUROPÄISCHE PATENTSCHRIFT**

(45) Veröffentlichungstag und Bekanntmachung des Hinweises auf die Patenterteilung:
**16.08.2017 Patentblatt 2017/33**

(21) Anmeldenummer: **15182550.2**

(22) Anmeldetag: **26.08.2015**

(51) Int Cl.:
*H02P 6/12* (2006.01)      *H02P 23/02* (2006.01)
*G01R 31/34* (2006.01)      *H02P 29/024* (2016.01)

(54) **ÜBERWACHUNGSVORRICHTUNG FÜR EINE ELEKTROMASCHINE, STEUERVORRICHTUNG UND VERFAHREN**

MONITORING DEVICE FOR AN ELECTRIC MACHINE, CONTROL DEVICE AND METHOD

DISPOSITIF DE SURVEILLANCE D'UNE MACHINE ELECTRIQUE, DISPOSITIF DE COMMANDE ET PROCEDE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **16.09.2014 DE 102014218583**

(43) Veröffentlichungstag der Anmeldung:
**23.03.2016 Patentblatt 2016/12**

(73) Patentinhaber: **Brose Fahrzeugteile GmbH & Co. Kommanditgesellschaft, Würzburg 97076 Würzburg (DE)**

(72) Erfinder:
• **KRONEWALD, Maxim 97204 Höchberg (DE)**

• **JOACHIMSMEYER, Dirk 97262 Hausen (DE)**

(74) Vertreter: **Isarpatent Patent- und Rechtsanwälte Behnisch Barth Charles Hassa Peckmann & Partner mbB Friedrichstrasse 31 80801 München (DE)**

(56) Entgegenhaltungen:
**WO-A1-2013/184143     DE-A1-102009 048 944
US-A1- 2011 074 322     US-B2- 7 042 180**

**Beschreibung**

Die vorliegende Erfindung bezieht sich auf eine Überwachungsvorrichtung für eine Elektromaschine, eine Steuervorrichtung für eine Elektromaschine und ein Verfahren zum Überwachen einer Elektromaschine.

STAND DER TECHNIK

Elektromaschinen werden heute in einer Vielzahl unterschiedlicher Anwendungen eingesetzt. Dabei ist der Einsatz sogenannter bürstenloser Elektromaschinen insbesondere in Anwendungen, in welchen eine hohe Verfügbarkeit und Langlebigkeit der Elektromaschinen von Bedeutung ist vorteilhaft, da bei diesen kein Verschleiß der Bürsten auftritt. Beispielsweise können solche Elektromaschinen in Fahrzeugen als Gebläsemotoren eingesetzt werden, um z.B. die Klimatisierung des Fahrzeugs zu ermöglichen. Die WO 2013/184143 A1 (SCHNEIDER ELECTRIC USA, 12.12.2013) offenbart eine Überwachungsvorrichtung für Elektromaschinen mit einer Erfassungseinrichtung, welche ausgebildet ist, eine der Elektromaschine zugeführte elektrische Leistung zu erfassen.

Durch Fehler der Elektromaschine oder durch äußere Einflüsse kann es im Betrieb einer Elektromaschine zu einer Blockade des Rotors der Elektromaschine kommen. Eine solche Blockade muss durch die Ansteuerelektronik erkannt werden und die Stromzufuhr zu der Elektromaschine unterbrochen werden, um dauerhafte Schäden an der Leistungselektronik oder der Elektromaschine zu verhindern.

Heute existieren unterschiedliche Möglichkeiten, eine Blockade des Rotors einer Elektromaschine zu detektieren. Dabei ist es wünschenswert eine Blockadeerkennung ohne einen zusätzlichen Positionssensor durchzuführen, da dieser die Systemkomplexität und die Kosten erhöht.

Eine Blockadeerkennung kann beispielsweise basierend auf einer Drehzahl eines in der Ansteuerung der Elektromaschine verwendeten Kalmanfilters durchgeführt werden. Allerdings ist diese Erkennung sehr ungenau und kann daher zu einem Nichterkennen einer Blockade des Rotors einer Elektromaschine führen.

Alternativ können modellbasierte Verfahren genutzt werden, um eine Blockade des Rotors der Elektromaschine zu erkennen. Diese Verfahren funktionieren aber lediglich im oberen Drehzahlbereich der Elektromaschine zuverlässig, da im unteren Drehzahlbereich der Elektromaschine die messbare Gegen-EMK sehr gering ist.

OFFENBARUNG DER ERFINDUNG

Es ist daher eine Aufgabe der vorliegenden Erfindung eine einfache Möglichkeit zur Erkennung einer Rotorblockade bei einer Elektromaschine bereitzustellen.

Demgemäß offenbart die vorliegende Erfindung eine Überwachungsvorrichtung gemäß Anspruch 1, eine Steuervorrichtung gemäß Anspruch 7 und ein Verfahren gemäß Anspruch 9.

Demgemäß ist vorgesehen:

Eine Überwachungsvorrichtung für eine Elektromaschine, mit einer ersten Erfassungseinrichtung, welche ausgebildet ist, eine der Elektromaschine zugeführte elektrische Leistung zu erfassen, mit einer zweiten Erfassungseinrichtung, welche ausgebildet ist, basierend auf einer Kommutierung der Elektromaschine eine von der Elektromaschine abgegebene theoretische mechanische Leistung zu erfassen, und mit einer Recheneinrichtung, welche ausgebildet ist, basierend auf der erfassten elektrischen Leistung und der erfassten theoretischen mechanischen Leistung einen Wirkungsgrad der Elektromaschine zu berechnen und ein Fehlersignal auszugeben, wenn der berechnete Wirkungsgrad größer als 1 ist.

Ferner ist vorgesehen:

Eine Steuervorrichtung für eine Elektromaschine, mit einer Ansteuerelektronik, welche ausgebildet ist, die Elektromaschine basierend auf einer vorgegebenen Drehzahl anzusteuern, und mit einer erfindungsgemäßen Überwachungsvorrichtung, wobei die Ansteuerelektronik ausgebildet ist, die Elektromaschine spannungslos und/oder stromlos zu stellen, wenn die Überwachungsvorrichtung ein Fehlersignal ausgibt.

Schließlich ist vorgesehen:

Ein Verfahren zum Überwachen einer Elektromaschine, aufweisend Erfassen einer der Elektromaschine zugeführten elektrischen Leistung, Erfassen einer von der Elektromaschine abgegebenen theoretischen mechanischen Leistung basierend auf einer Kommutierung der Elektromaschine, Berechnen eines Wirkungsgrads der Elektromaschine basierend auf der erfassten elektrischen Leistung und der erfassten theoretischen mechanischen Leistung, und Ausgeben eines Fehlersignals, wenn der berechnete Wirkungsgrad größer als 1 ist.

VORTEILE DER ERFINDUNG

Die der vorliegenden Erfindung zu Grunde liegende Erkenntnis besteht darin, dass bei einem blockierten Rotor einer Elektromaschine die Werte für eine elektrische Leistung und eine theoretische mechanische Leistung der Elektromaschine voneinander abweichen.

Dabei bezeichnet die theoretische mechanische Leistung, diejenige mechanische Leistung, die sich aus einer theoretischen Berechnung der mechanischen Leistung basierend zumindest auf einer Drehzahl, bzw. einer durch die Kommutierung der Elektromaschine vorgegebenen Drehzahl, ergit.

Die der vorliegenden Erfindung zu Grunde liegende Idee besteht nun darin, dieser Erkenntnis Rechnung zu tragen und eine Möglichkeit vorzusehen, basierend auf der Abweichung zwischen elektrischer Leistung und theoretischen mechanischer Leistung der Elektromaschine eine Blockade des Rotors der Elektromaschine zu erkennen.

Dazu sieht die vorliegende Erfindung eine Überwachungsvorrichtung vor, in welcher mit einer ersten Erfassungseinrichtung die der Elektromaschine zugeführte elektrische Leistung erfasst wird und mit einer zweiten Erfassungseinrichtung eine von der Elektromaschine abgegebene theoretische mechanische Leistung erfasst wird.

Erfindungsgemäß berechnet eine Recheneinrichtung aus der elektrischen Leistung und der thoretischen mechanischen Leistung den Wirkungsgrad der Elektromaschine und gibt ein Fehlersignal aus, wenn dieser größer als 1 ist.

Das erfindungsgemäße Verfahren ist dabei insbesondere bürstenlose Elektromaschinen, z.B. auf PMSM (Permanent Magnet Synchronous Motor) Maschinen, anzuwenden.

Die vorliegende Erfindung macht sich zunutze, dass die Motorelektronik, welche die Elektromaschine ansteuert, die Kommutierung der Elektromaschine weiterführt, auch, wenn der Rotor der Elektromaschine blockiert ist.

Dadurch ergibt sich für den Fall einer Blockade des Rotors der Elektromaschine bei der Berechnung der theoretischen mechanischen Leistung ein höherer Wert, als für die elektrische Leistung, was dazu führt, dass der berechnete Wirkungsgrad größer als 1 wird.

In der erfindungsgemäßen Steuervorrichtung ist die Überwachungsvorrichtung mit einer Ansteuerelektronik gekoppelt, welche basierend auf dem Fehlersignal die Elektromaschine spannungslos bzw. stromlos stellt, also die Ansteuerung der Elektromaschine beendet.

Vorteilhafte Ausführungsformen und Weiterbildungen ergeben sich aus den Unteransprüchen sowie aus der Beschreibung unter Bezugnahme auf die Figuren.

In einer Ausführungsform ist die erste Erfassungseinrichtung ausgebildet, die der Elektromaschine zugeführte elektrische Leistung basierend auf einer der Elektromaschine zugeführten elektrischen Spannung und einem der Elektromaschine zugeführten elektrischen Strom zu berechnen. Dies ermöglicht eine sehr einfache Berechnung der der Elektromaschine zugeführten elektrischen Leistung.

In einer Ausführungsform weist die erste Erfassungseinrichtung einen Spannungssensor zur Erfassung der der Elektromaschine zugeführten elektrischen Spannung auf. So kann die der Elektromaschine zugeführten elektrische Spannung direkt in der Erfassungseinrichtung gemessen werden.

In einer Ausführungsform weist die erste Erfassungseinrichtung einen Stromsensor zur Erfassung des der Elektromaschine zugeführten elektrischen Stroms auf. So kann der der Elektromaschine zugeführte elektrische Strom direkt in der Erfassungseinrichtung gemessen werden.

In einer Ausführungsform weist die erste Erfassungseinrichtung eine Messdatenschnittstelle auf und ist ausgebildet, über die Messdatenschnittstelle die der Elektromaschine zugeführte elektrische Spannung und/oder den der Elektromaschine zugeführten elektrischen Strom zu erfassen. Dadurch können z.B. die in der Ansteuerelektronik der Steuervorrichtung bereits verfügbaren Werte für die der Elektromaschine zugeführte elektrische Spannung und den der Elektromaschine zugeführten elektrischen Strom weiterverwendet werden und müssen nicht separat erfasst werden.

In einer Ausführungsform ist die zweite Erfassungseinrichtung ausgebildet, die von der Elektromaschine abgegebene theoretische mechanische Leistung basierend auf einem Drehmoment der Elektromaschine und einer durch die Kommutierung vorgegebenen Drehzahl der Elektromaschine zu berechnen. Dies ermöglicht eine sehr einfach und effiziente Berechnung der mechanischen Leistung.

Beispielsweise kann die mechanische Leistung basierend auf folgender Formel berechnet werden:

$$P_{mech} = 2 * \pi * M * n$$

Dabei steht M für das Drehmoment und n für die Drehzahl. Die Drehzahl ist durch die Kommutierung der Elektromaschine vorgegeben. Das Drehmoment kann z.B. für eine Ansteuerung der Elektromaschine ohne Feldschwächung berechnet werden nach folgender Formel:

$$M = \frac{3}{2} * Polpaarzahl * I_q * \Psi$$

Dabei steht $I_q$ für den q-Achsenstrom im Rotorfesten Koordinatensystem und $\Psi$ für den magnetischen Fluss.

In einer Ausführungsform ist die Recheneinrichtung ausgebildet, den Wirkungsgrad über einen vorgegebenen Zeitraum zu berechnen und das Fehlersignal auszugeben, wenn der Wirkungsgrad über den gesamten Zeitraum größer als 1 ist. Dadurch kann eine Abschaltung der Elektromaschine verhindert werden, wenn die Blockade nur kurzzeitig besteht oder auf Grund von Störungen ein Fehler in den Berechnungen vorliegt.

In einer Ausführungsform weist die Ansteuerelektronik mindestens einen Spannungssensor zur Erfassung einer der Elektromaschine bereitgestellten elektrischen Spannung auf und ist ausgebildet, einen Wert, welcher die erfasste elektrische Spannung kennzeichnet, der Überwachungsvorrichtung bereitzustellen. Dadurch kann der in der Ansteuerelektronik bereits vorhandene Spannungssensor auch für die Überwachungsvorrichtung genutzt werden.

In einer Ausführungsform weist die Ansteuerelektronik mindestens einen Stromsensor zur Erfassung eines der Elektromaschine bereitgestellten elektrischen Stroms auf und ist ausgebildet, einen Wert, welcher den erfassten elektrischen Strom kennzeichnet, der Überwachungsvorrichtung bereitzustellen. Dadurch kann der in der Ansteuerelektronik bereits vorhandene Stromsensor auch für die Überwachungsvorrichtung genutzt werden.

Die obigen Ausgestaltungen und Weiterbildungen lassen sich, sofern sinnvoll, beliebig miteinander kombinieren. Weitere mögliche Ausgestaltungen, Weiterbildungen und Implementierungen der Erfindung umfassen auch nicht explizit genannte Kombinationen von zuvor oder im Folgenden bezüglich der Ausführungsbeispiele beschriebenen Merkmalen der Erfindung. Insbesondere wird dabei der Fachmann auch Einzelaspekte als Verbesserungen oder Ergänzungen zu der jeweiligen Grundform der vorliegenden Erfindung hinzufügen.

KURZE BESCHREIBUNG DER ZEICHNUNGEN

Die vorliegende Erfindung wird nachfolgend anhand der in den schematischen Figuren der Zeichnungen angegebenen Ausführungsbeispiele näher erläutert. Es zeigen dabei:

Fig. 1    ein Blockschaltbild einer Ausführungsform der erfindungsgemäßen Überwachungsvorrichtung;

Fig. 2    ein Blockschaltbild einer Ausführungsform der erfindungsgemäßen Steuervorrichtung;

Fig. 3    ein Ablaufdiagramm einer Ausführungsform des erfindungsgemäßen Verfahrens;

Fig. 4    ein Diagramm mit dem Verlauf einer mechanischen Leistung und dem Verlauf einer elektrischen Leistung einer Elektromaschine.

In allen Figuren sind gleiche bzw. funktionsgleiche Elemente und Vorrichtungen - sofern nichts Anderes angegeben ist - mit denselben Bezugszeichen versehen worden.

AUSFÜHRUNGSFORMEN DER ERFINDUNG

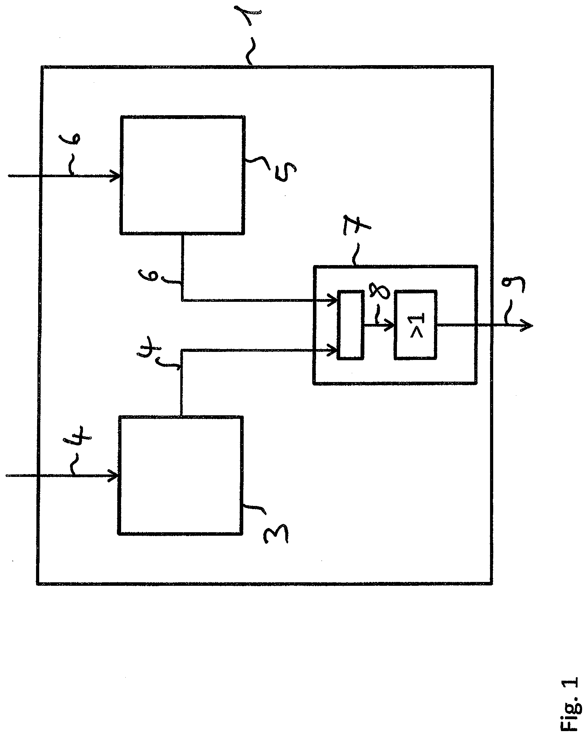

Fig. 1 zeigt ein Blockschaltbild einer Ausführungsform der erfindungsgemäßen Überwachungsvorrichtung 1.

Die Überwachungsvorrichtung 1 der Fig. 1 weist eine erste Erfassungseinrichtung 3 auf, die die elektrische Leistung 4 erfasst, die der zu steuernden Elektromaschine 2 (in Fig. 1 nicht dargestellt) zugeführt wird.

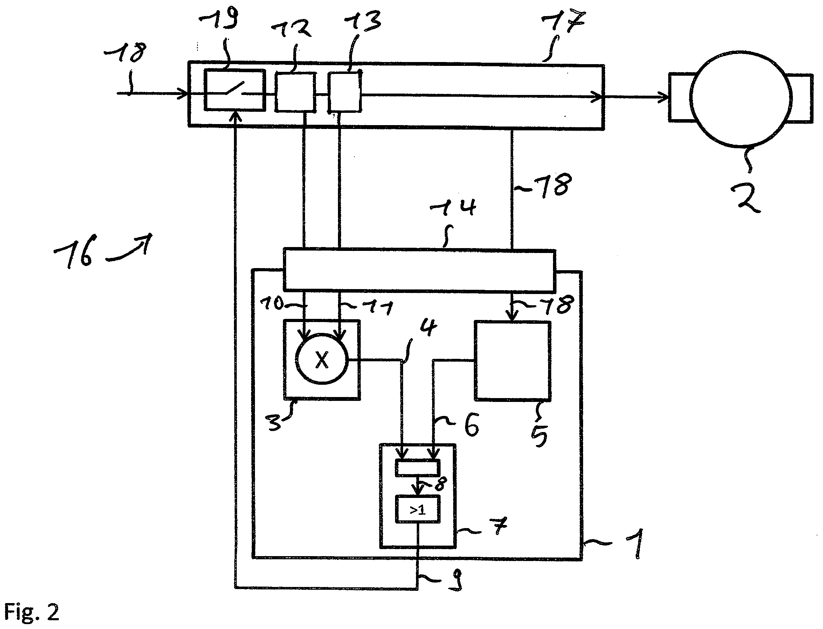

Dazu kann in einer Ausführungsform die erste Erfassungseinrichtung 3 z.B. die Spannung 10 und den Strom 11 erfassen, die der Elektromaschine 2 zugeführt werden. Dies wird in Fig. 2 dargestellt.

Die Überwachungsvorrichtung 1 weist ferner eine zweite Erfassungseinrichtung 5 auf, die die mechanische Leistung 6 erfasst, die der Elektromaschine 2 zugeführt wird. Dabei kann die zweite Erfassungseinrichtung 5 die mechanische Leistung 6 in einer Ausführungsform z.B. basierend auf folgender Formel berechnen:

$$P_{mech} = 2 * \pi * M * n$$

Dabei steht M für das Drehmoment und n für die Drehzahl 18, die durch die Kommutierung der Elektromaschine 2 vorgegeben wird.

Das Drehmoment M kann in einer Ausführungsform z.B. für eine Ansteuerung der Elektromaschine 2 ohne Feldschwächung berechnet werden nach folgender Formel:

$$M = \frac{3}{2} * Polpaarzahl * I_q * \Psi$$

Dabei steht Iq für den q-Achsenstrom im Rotorfesten Koordinatensystem und Ψ für den magnetischen Fluss.

Für den Fall, dass die Elektromaschine 2 mit Feldschwächung betrieben wird, ergibt sich das Moment M aus folgender Formel:

$$M = \frac{3}{2} * Polpaarzahl * \left( I_q * \Psi + I_q * I_d * \left( L_d - L_q \right) \right)$$

Dabei steht $I_d$ für den d-Achsenstrom im Rotorfesten Koordinatensystem und $L_d$ bzw. $L_q$ für die jeweiligen Induktivitäten. Die erste Erfassungseinrichtung 3 stellt den Wert für die elektrische Leistung 4 einer Recheneinrichtung 7 der Überwachungsvorrichtung 1 bereit. Die zweite Erfassungseinrichtung 5 stellt der Recheneinrichtung 7 dagegen den Wert für die theoretische mechanische Leistung 6 der Elektromaschine 2 bereit.

Aus diesen zwei Leistungswerten 4 und 6 berechnet die Recheneinrichtung 7 einen Wirkungsgrad 8. Dies kann in einer Ausführungsform z.B. durch Division der elektrischen Leistung 4 durch die mechanische Leistung 6 erfolgen.

Im Fehlerfall, also bei blockiertem Rotor der Elektromaschine 2 berechnet die zweite Erfassungseinrichtung 5 die mechanische Leistung 6 der Elektromaschine 2 weiterhin basierend auf der Drehzahl, welche durch die Kommutierung der Elektromaschine 2 vorgegeben wird. Daher ergibt sich eine größere mechanische Leistung 6, als eigentlich von der Elektromaschine 2 abgegeben wird.

Wird nun der Wirkungsgrad 8 aus elektrischer Leistung 4 und mechanischer Leistung 6 berechnet, ergibt sich durch die höhere mechanische Leistung 6 ein Wirkungsgrad 8 von größer 1. Da dies physikalisch aber nicht möglich ist, kann aus diesem Wirkungsgrad 8 darauf geschlossen werden, dass der Rotor der Elektromaschine 2 blockiert ist.

In solch einem Fall gibt die Recheneinrichtung 7 ein Fehlersignal 9 aus, dass z.B. von einer Motorsteuerung der Elektromaschine 2 ausgewertet werden kann.

In einer Ausführungsform kann die Überwachungsvorrichtung 1 als eine eigene Steuereinheit ausgebildet sein. In solch einer Ausführungsform kann die Überwachungsvorrichtung 1 z.B. über ein Bussystem, z.B. einen CAN-Bus, mit einer Motorsteuerung der Elektromaschine 2 gekoppelt sein.

In einer weiteren Ausführungsform kann die Überwachungsvorrichtung 1 aber auch als Bestandteil einer Steuervorrichtung 16 für eine Elektromaschine 2 ausgebildet sein.

Dazu kann die Überwachungsvorrichtung 1 z.B. als Programmmodul ausgebildet sein, welches auf einem Prozessor der Steuervorrichtung 16 ausgeführt wird. Dabei kann das Programmmodul parallel zu weiteren Programmmodulen ausgeführt werden, die für die Steuerung der Elektromaschine 2 notwendig sind.

Die Überwachungsvorrichtung 1 kann aber auch als separate Einheit in der Steuervorrichtung 16 ausgebildet sein, die über diskrete Leitungen oder ein Bussystem mit den weiteren Komponenten der Steuervorrichtung 16 gekoppelt ist. Dies erhöht die Ausfallsicherheit des Gesamtsystems.

Wird die Überwachungsvorrichtung 1 in einem Fahrzeug eingesetzt und z.B. zur Überwachung von Lüftermotoren der Klimaanlage des Fahrzeugs genutzt, kann die Überwachungsvorrichtung 1 z.B. mit einem Fahrzeugbus, z.B. einem CAN-Bus oder einem FlexRay-Bus, gekoppelt sein und das Fehlersignal 9 z.B. an ein übergeordnetes Fahrzeugsteuergerät übermitteln, welches das Fehlersignal 9 auswertet und geeignete Maßnahmen ergreift. Z.B. kann die Leistung der Klimaanlage eingeschränkt werden. Es können aber auch die verbleibenden Lüftermotoren mit erhöhter Leistung angesteuert werden, um den Ausfall zu kompensieren. Z.B. kann dem Fahrer des Fahrzeugs auch angezeigt werden, dass ein Service durchgeführt werden sollte.

Fig. 2 zeigt ein Blockschaltbild einer Ausführungsform der erfindungsgemäßen Steuervorrichtung 16.

Die Steuervorrichtung 16 der Fig. 2 weist eine Überwachungsvorrichtung 1 auf, welche auf der Überwachungsvorrichtung 1 der Fig. 1 basiert.

Im Unterschied zu Fig. 1 weist die Überwachungsvorrichtung 1 der Fig. 2 eine Messdatenschnittstelle 14 auf, über welche die Überwachungsvorrichtung 1 die der Elektromaschine 2 zugeführte Spannung 10 und den der Elektromaschine 2 zugeführten Strom 11 erfasst. Ferner erfasst die Überwachungsvorrichtung 1 über die Messdatenschnittstelle 14 auch die Drehzahl 18, welche durch die Kommutierung der Elektromaschine 2 vorgegeben wird. In einer Ausführungsform kann die Überwachungseinrichtung 1 über die Messdatenschnittstelle 14 auch die Wert des Stroms Iq und des magnetischen Flusses ψ erfassen.

Die Steuervorrichtung 16 der Fig. 2 weist ferner eine Ansteuerelektronik 17 auf, die eine vorgegebene Drehzahl 18 erhält und basierend auf dieser vorgegebenen Drehzahl 18 die Elektromaschine 2 ansteuert.

In Fig. 2 nicht dargestellt sind die dem Fachmann bekannten Elemente der Ansteuerelektronik 17, wie z.B. der Inverter oder dergleichen. Der Übersichtlichkeit halber sind lediglich diejenigen Komponenten der Ansteuerelektronik 17 dargestellt, die zur Erklärung der Funktion der vorliegenden Erfindung notwendig sind.

Die Ansteuerelektronik 17 weist einen Spannungssensor 12 und einen Stromsensor 13 auf, die die der Elektromaschine 2 zugeführte elektrische Spannung 10 bzw. den der Elektromaschine 2 zugeführten elektrischen Strom 11 erfassen und der Überwachungsvorrichtung 1 über deren Messdatenschnittstelle 14 bereitstellen. Die Ansteuerelektronik 17 stellt der Überwachungseinrichtung 1 über die Messdatenschnittstelle 14 ferner die durch die Kommutierung der Elektromaschine 2 vorgegebene Drehzahl 18 bereit.

Wie bereits oben erläutert, kann die erste Erfassungseinrichtung 3 aus der der Elektromaschine 2 zugeführten elektrischen Spannung 10 und dem der Elektromaschine 2 zugeführten elektrischen Strom 11 die elektrische Leistung 4 berechnen, die der Elektromaschine 2 zugeführt wird. Basierend auf der Drehzahl 18 und je nach Ausführung dem Strom Iq und dem magnetischen Fluss $\psi$ kann die zweite Erfassungseinrichtung 5 die von der Elektromaschine 2 abgegebene theoretische mechanische Leistung 6 berechnen.

Das Fehlersignal 9, welches die Recheneinrichtung 7 basierend auf der elektrischen Leistung 4 und der abgegebenen theoretischen mechanischen Leistung 6 berechnet, wird der Ansteuerelektronik 17 bereitgestellt, welche eine Abschaltautomatik 19 aufweist, welche in Fig. 2 als Schalter 19 dargestellt ist. Diese Abschaltautomatik 19 schaltet die Elektromaschine 2 stromlos bzw. spannungslos, wenn das Fehlersignal 9 anliegt.

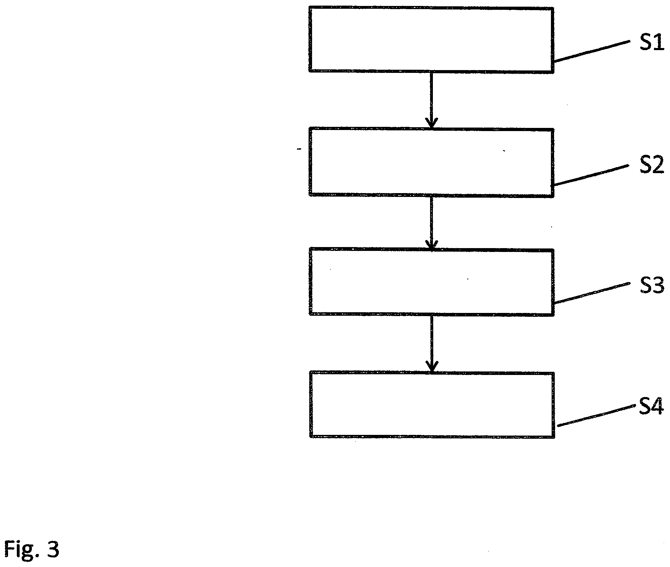

Fig. 3 zeigt ein Ablaufdiagramm einer Ausführungsform des erfindungsgemäßen Verfahrens.

Das Verfahren zum Überwachen einer Elektromaschine 2 weist das Erfassen S1 einer der Elektromaschine 2 zugeführten elektrischen Leistung 4 auf. Ferner weist das Verfahren das Erfassen S2 einer von der Elektromaschine 2 abgegebenen theoretischen mechanischen Leistung 6 basierend auf einer Kommutierung der Elektromaschine 2 auf. Aus der erfassten elektrischen Leistung 4 und der erfassten theoretischen mechanischen Leistung 6 wird ein Wirkungsgrad 8 der Elektromaschine 2 berechnet, S3.

Schließlich wird ein Fehlersignals 9 ausgegeben, S4, wenn der berechnete Wirkungsgrad 8 größer als 1 ist.

In einer Ausführungsform des Verfahrens kann die der Elektromaschine 2 zugeführte elektrische Leistung 4 basierend auf einer der Elektromaschine 2 zugeführten elektrischen Spannung 10 und einem der Elektromaschine 2 zugeführten elektrischen Strom 11 berechnet werden. Beispielsweise kann eine einfache Multiplikation der zwei Werte erfolgen, um die elektrische Leistung 4 zu berechnen.

Die der Elektromaschine 2 zugeführte elektrische Spannung 10 kann dabei in einer Ausführungsform durch einen Spannungssensor 12 direkt erfasst werden. Zusätzlich oder alternativ kann der der Elektromaschine 2 zugeführte elektrische Strom 11 in einer Ausführungsform durch einen Stromsensor 13 erfasst werden.

In einer Ausführungsform können die der Elektromaschine 2 zugeführte elektrische Spannung 10 und/oder der der Elektromaschine 2 zugeführte elektrische Strom 11 von nicht zur Ausführung des Verfahrens benutzten Steuereinrichtungen bereitgestellt werden und z.B. über eine Messdatenschnittstelle 14 erfasst werden.

Die von der Elektromaschine 2 abgegebene theoretische mechanische Leistung 6 kann in einer Ausführungsform basierend auf einem Drehmoment der Elektromaschine 2 und einer durch die Kommutierung vorgegebenen Drehzahl 18 der Elektromaschine 2 berechnet werden. Die Formeln zu Berechnung der mechanische Leistung 6 sind bereits in Zusammenhang mit Fig. 1 erläutert worden.

Schließlich kann in einer Ausführungsform der Wirkungsgrad 8 über einen vorgegebenen Zeitraum 15 berechnet werden und das Fehlersignal 9 ausgegeben werden, wenn der Wirkungsgrad 8 über den gesamten Zeitraum größer als 1 ist.

Das erfindungsgemäße Verfahren kann z.B. als Programmprodukt ausgebildet sein und in einem Fahrzeugsteuergerät eines Fahrzeugs ausgeführt werden. Dabei kann das Fahrzeugsteuergerät z.B. ein Motorsteuergerät sein, welches auch die Steuerung der Elektromaschine 2 ausführt.

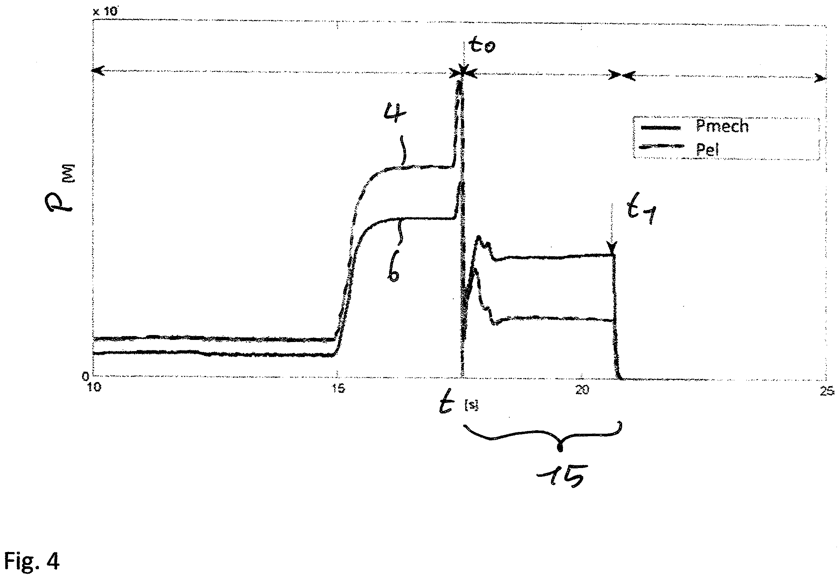

Fig. 4 zeigt ein Diagramm mit dem Verlauf einer mechanischen Leistung 6 (durchgehende Linie) und dem Verlauf einer elektrischen Leistung 4 (gestrichelte Linie) einer Elektromaschine 2.

Die Ordinatenachse des Diagramms zeigt die Leistung in Watt und die Abszissenachse des Diagramms zeigt die Zeit in Sekunden von 10 Sekunden bis 25 Sekunden.

Die in dem Diagramm der Fig. 4 gezeigten Verläufe sind lediglich beispielhaft und können für unterschiedliche Elektromaschinen 2 und unterschiedliche Ausführungsformen der vorliegenden Erfindung von den dargestellten Verläufen abweichen.

Die Kurve für die elektrische Leistung 4 verläuft bis zu einem Zeitpunkt von 15s bei etwa 150W. In etwa parallel zu dieser Kurve verläuft die Kurve für die mechanische Leistung 6 bei etwa 120W. Zwischen 15s und dem Zeitpunkt t0 bei ca. 17,5s steigt die elektrische Leistung 4 an und die mechanische Leistung 6 folgt dem Anstieg der elektrischen Leistung, wobei ein starker Anstieg der elektrischen und der mechanischen Leistung 4, 6 kurz vor Erreichen des Zeitpunkts t0 zu erkennen ist. Zum Zeitpunkt t0 ist der Rotor der Elektromaschine 2 blockiert. Zum Zeitpunkt t0 sinken sowohl die elektrische Leistung 4 als auch die mechanische Leistung 6 auf 0W.

Gleich darauf steigt die elektrische Leistung 4 auf ca. 41W und die mechanische Leistung 6 auf ca. 85W. Bis zum Zeitpunkt t1, bei etwa 22s, verlaufen die elektrische Leistung 4 und die mechanische Leistung 6 in etwa konstant.

Es ist zu erkennen, dass die mechanische Leistung 6 einen höheren Wert annimmt, als die elektrische Leistung 4. Wie bereits erläutert wird zur Berechnung der mechanischen Leistung 6 die Drehzahl genutzt, welche durch die Kommutierung der Elektromaschine 2 bei nicht-blockiertem Rotor eingestellt würde. So lange also die Kommutierung der Elektromaschine 2 fortgesetzt wird, kann die größere mechanische Leistung 6 als Indiz für einen blockierten Rotor genutzt werden.

Die Differenz zwischen dem Zeitpunkt t0 und dem Zeitpunkt t1 entspricht einem vorgegebenen Zeitraum 15, welcher als Timeout oder Sicherheitspuffer für die Erkennung eines blockierten Rotors der Elektromaschine 2 dient.

Ab dem Zeitpunkt t1 sinken sowohl die elektrische Leistung 4 als auch die mechanische Leistung 6 auf 0, da die Ansteuerelektronik 17 die Kommutierung der Elektromaschine 2 zu diesem Zeitpunkt abbricht.

Obwohl die vorliegende Erfindung anhand bevorzugter Ausführungsbeispiele vorstehend beschrieben wurde, ist sie darauf nicht beschränkt, sondern auf vielfältige Art und Weise modifizierbar. Insbesondere lässt sich die Erfindung in mannigfaltiger Weise verändern oder modifizieren, ohne vom Kern der Erfindung abzuweichen.

BEZUGSZEICHEN

| 1 | Überwachungsvorrichtung |
| 2 | Elektromaschine |
| 3 | erste Erfassungseinrichtung |
| 4 | elektrische Leistung |
| 5 | zweite Erfassungseinrichtung |
| 6 | theoretische mechanische Leistung |
| 7 | Recheneinrichtung |
| 8 | Wirkungsgrad |
| 9 | Fehlersignal |
| 10 | elektrische Spannung |
| 11 | elektrischer Strom |
| 12 | Spannungssensor |
| 13 | Stromsensor |
| 14 | Messdatenschnittstelle |
| 15 | vorgegebener Zeitraum |
| 16 | Steuervorrichtung |
| 17 | Ansteuerelektronik |
| 18 | vorgegebene Drehzahl |
| 19 | Schalter |

t0, t1  Zeitpunkte

S1 - S4  Verfahrensschritte

**Patentansprüche**

1. Überwachungsvorrichtung (1) für eine Elektromaschine (2),
mit einer ersten Erfassungseinrichtung (3), welche ausgebildet ist, eine der Elektromaschine (2) zugeführte elektrische Leistung (4) zu erfassen; **gekennzeichnet durch** eine zweite Erfassungseinrichtung (5), welche ausgebildet ist, basierend auf einer Kommutierung der Elektromaschine (2) eine von der Elektromaschine (2) abgegebene theoretische mechanische Leistung (6) zu erfassen; und eine Recheneinrichtung (7), welche ausgebildet ist, basierend auf der erfassten elektrischen Leistung (4) und der erfassten theoretischen mechanischen Leistung (6) einen Wirkungsgrad (8) der Elektromaschine (2) zu berechnen und ein Fehlersignal (9) auszugeben, wenn der berechnete Wirkungsgrad (8) größer als 1 ist.

2. Überwachungsvorrichtung nach Anspruch 1,
wobei die erste Erfassungseinrichtung (3) ausgebildet ist, die der Elektromaschine (2) zugeführte elektrische Leistung (4) basierend auf einer der Elektromaschine (2) zugeführten elektrischen Spannung (10) und einem der Elektromaschine (2) zugeführten elektrischen Strom (11) zu berechnen.

3.  Überwachungsvorrichtung nach Anspruch 2,
    wobei die erste Erfassungseinrichtung (3) einen Spannungssensor (12) zur Erfassung der der Elektromaschine (2) zugeführten elektrischen Spannung (10) aufweist; und/oder wobei die erste Erfassungseinrichtung (3) einen Stromsensor (13) zur Erfassung des der Elektromaschine (2) zugeführten elektrischen Stroms aufweist.

4.  Überwachungsvorrichtung nach einem der Ansprüche 2 und 3,
    wobei die erste Erfassungseinrichtung (3) eine Messdatenschnittstelle (14) aufweist und ausgebildet ist, über die Messdatenschnittstelle (14) die der Elektromaschine (2) zugeführte elektrische Spannung (10) und/oder den der Elektromaschine (2) zugeführten elektrischen Strom (11) zu erfassen.

5.  Überwachungsvorrichtung nach einem der vorherigen Ansprüche,
    wobei die zweite Erfassungseinrichtung (5) ausgebildet ist, die von der Elektromaschine (2) abgegebene theoretische mechanische Leistung (6) basierend auf einem Drehmoment der Elektromaschine (2) und einer durch die Kommutierung vorgegebenen Drehzahl (18) der Elektromaschine (2) zu berechnen.

6.  Überwachungsvorrichtung nach einem der vorherigen Ansprüche,
    wobei die Recheneinrichtung (7) ausgebildet ist, den Wirkungsgrad (8) über einen vorgegebenen Zeitraum (15) zu berechnen und das Fehlersignal (9) auszugeben, wenn der Wirkungsgrad (8) über den gesamten Zeitraum größer als 1 ist.

7.  Steuervorrichtung (16) für eine Elektromaschine (2),
    mit einer Ansteuerelektronik (17), welche ausgebildet ist, die Elektromaschine (2) basierend auf einer vorgegebenen Drehzahl (18) anzusteuern; und
    mit einer Überwachungsvorrichtung (1) nach einem der vorherigen Ansprüche;
    wobei die Ansteuerelektronik (17) ausgebildet ist, die Elektromaschine (2) spannungslos und/oder stromlos zu stellen, wenn die Überwachungsvorrichtung (1) ein Fehlersignal (9) ausgibt.

8.  Steuervorrichtung nach Anspruch 7,
    wobei die Ansteuerelektronik (17) mindestens einen Spannungssensor (12) zur Erfassung einer der Elektromaschine (2) bereitgestellten elektrischen Spannung (10) aufweist und ausgebildet ist, einen Wert welcher die erfasste elektrischen Spannung (10) kennzeichnet, der Überwachungsvorrichtung (1) bereitzustellen; und/oder
    wobei die Ansteuerelektronik (17) mindestens einen Stromsensor (13) zur Erfassung eines der Elektromaschine (2) bereitgestellten elektrischen Stroms (11) aufweist und ausgebildet ist, einen Wert welcher den erfassten elektrischen Strom (11) kennzeichnet, der Überwachungsvorrichtung (1) bereitzustellen.

9.  Verfahren zum Überwachen einer Elektromaschine (2), aufweisend:

    Erfassen (S1) einer der Elektromaschine (2) zugeführten elektrischen Leistung (4); **gekennzeichnet durch**
    Erfassen (S2) einer von der Elektromaschine (2) abgegebenen theoretischen mechanischen Leistung (6) basierend auf einer Kommutierung der Elektromaschine (2);
    Berechnen (S3) eines Wirkungsgrads (8) der Elektromaschine (2) basierend auf der erfassten elektrischen Leistung (4) und der erfassten theoretischen mechanischen Leistung (6); und
    Ausgeben (S4) eines Fehlersignals (9), wenn der berechnete Wirkungsgrad (8) größer als 1 ist.

10. Verfahren nach Anspruch 9,
    wobei die der Elektromaschine (2) zugeführte elektrische Leistung (4) basierend auf einer der Elektromaschine (2) zugeführten elektrischen Spannung (10) und einem der Elektromaschine (2) zugeführten elektrischen Strom (11) berechnet wird.

11. Verfahren nach Anspruch 10,
    wobei die der Elektromaschine (2) zugeführte elektrische Spannung (10) durch einen Spannungssensor (12) erfasst wird; und/oder
    wobei der der Elektromaschine (2) zugeführte elektrische Strom (11) durch einen Stromsensor (13) erfasst wird.

12. Verfahren nach Anspruch 10 oder 11,
    wobei die der Elektromaschine (2) zugeführte elektrische Spannung (10) und/oder der der Elektromaschine (2) zugeführte elektrische Strom (11) über eine Messdatenschnittstelle (14) erfasst wird.

**13.** Verfahren nach einem der Ansprüche 9 bis 12,
wobei die von der Elektromaschine (2) abgegebene theoretische mechanische Leistung (6) basierend auf einem Drehmoment der Elektromaschine (2) und einer durch die Kommutierung vorgegebenen Drehzahl (18) der Elektromaschine (2) berechnet wird.

**14.** Verfahren nach einem der Ansprüche 9 bis 13,
wobei der Wirkungsgrad (8) über einen vorgegebenen Zeitraum (15) berechnet wird und das Fehlersignal (9) ausgegeben wird, wenn der Wirkungsgrad (8) über den gesamten Zeitraum größer als 1 ist.

**Claims**

**1.** Monitoring device (1) for an electric machine (2),
having a first ascertaining device (3) that is configured so as to ascertain an electrical power (4) that is supplied to the electric machine (2),
**characterised by** means of a second ascertaining device (5) that is configured so as on the basis of a commutation of the electric machine (2) to ascertain a theoretical mechanical power (6) that is output by the electric machine (2), and a calculating device (7) that is configured so as on the basis of the ascertained electrical power (4) and the ascertained theoretical mechanical power (6) to calculate an efficiency (8) of the electric machine (2) and to emit an error signal (9) if the calculated efficiency (8) is greater than 1.

**2.** Monitoring device according to claim 1,
wherein the first ascertaining device (3) is configured so as on the basis of an electrical voltage (10) that is supplied to the electric machine (2) and an electrical current (11) that is supplied to the electric machine (2) to calculate the electrical power (4) that is supplied to the electric machine (2).

**3.** Monitoring device according to claim 2,
wherein the first ascertaining device (3) comprises a voltage sensor (12) for ascertaining the electrical voltage (10) that is supplied to the electric machine (2); and/or
wherein the first ascertaining device (3) comprises a current sensor (13) for ascertaining the electrical current that is supplied to the electric machine (2).

**4.** Monitoring device according to any one of the claims 2 and 3,
wherein the first ascertaining device (3) comprises a measuring data interface (14) and is configured so as to ascertain by way of the measuring data interface (14) the electrical voltage (10) that is supplied to the electric machine (2), and/or the electrical current (11) that is supplied to the electric machine (2).

**5.** Monitoring device according to any one of the preceding claims,
wherein the second ascertaining device (5) is configured so as on the basis of a torque of the electric machine (2) and a rotational speed (18) of the electric machine (2), said rotational speed being predetermined by means of the commutation, to calculate the theoretical mechanical power (6) that is output by the electric machine (2).

**6.** Monitoring device according to any one of the preceding claims,
wherein the calculating device (7) is configured so as to calculate the efficiency (8) over a predetermined period of time (15) and to output the error signal (9) if the efficiency (8) is greater than 1 over the entire period of time.

**7.** Control device (16) for an electric machine (2),
having a control electronics system (17) that is configured so as on the basis of a predetermined rotational speed (18) to control the electric machine (2), and
having a monitoring device (1) according to any one of the preceding claims, wherein the control electronics system (17) is configured so as to disconnect the voltage and/or current from the electric machine (2) if the monitoring device (1) outputs an error signal (9).

**8.** Control device according to claim 7,
wherein the control electronics system (17) comprises at least one voltage sensor (12) for ascertaining an electrical voltage (10) that is provided to the electric machine (2) and is configured so as to provide a value that characterises the ascertained electrical voltage (10) to the monitoring device (1); and/or
wherein the control electronics system (17) comprises at least one current sensor (13) for ascertaining an electrical current (11) that is provided to the electric machine (2) and is configured so as to provide a value to the monitoring device (1), said value characterising the electrical current (11) that is ascertained.

9. Method for monitoring an electric machine (2), comprising:

ascertaining (S1) an electrical power (4) that is supplied to the electric machine (2),
**characterised by** means of ascertaining (S2) on the basis of a commutation of the electric machine (2) a theoretical mechanical power (6) that is output by the electric machine (2),
calculating (S3) an efficiency (8) of the electric machine (2) on the basis of the ascertained electric power (4) and the ascertained theoretical mechanical power (6), and
outputting (S4) an error signal (9) if the calculated efficiency (8) is greater than 1.

10. Method according to claim 9,
wherein the electrical power (4) that is supplied to the electric machine (2) is calculated on the basis of an electrical voltage (10) that is supplied to the electric machine (2) and an electrical current (11) that is supplied to the electric machine (2).

11. Method according to claim 10,
wherein the electrical voltage (10) that is supplied to the electric machine (2) is ascertained by means of a voltage sensor (12), and/or
wherein the electrical current (11) that is supplied to the electric machine (2) is ascertained by means of a current sensor (13).

12. Method according to claim 10 or 11,
wherein the electrical voltage (10) that is supplied to the electric machine (2) and/or the electrical current (11) that is supplied to the electric machine (2) is ascertained by way of a measuring data interface (14).

13. Method according to any one of the claims 9 to 12,
wherein the theoretical mechanical power (6) that is output by the electric machine (2) is calculated on the basis of a torque of the electric machine (2) and a rotational speed (18) of the electric machine (2), said rotational speed being predetermined by means of the commutation.

14. Method according to any one of the claims 9 to 13,
wherein the efficiency (8) is calculated by way of a predetermined period of time (15) and the error signal is output if the efficiency (8) is greater than 1 for the entire period of time.


**Revendications**

1. Dispositif de surveillance (1) pour une machine électrique (2), comportant :

un premier moyen de détection (3), configuré pour détecter une puissance électrique (4) alimentée à la machine électrique (2);

**caractérisé par**
un second moyen de détection (5), configuré pour détecter, en se basant sur une commutation de la machine électrique (2), une puissance mécanique théorique (6) délivrée par la machine électrique (2) ;
et un moyen de calcul (7), configuré pour calculer un rendement (8) de la machine électrique (2), en se basant sur la puissance électrique détectée (4) et la puissance mécanique théorique détectée (6) et pour émettre un signal d'erreur (9), lorsque le rendement calculé (8) est supérieur à 1.

2. Dispositif de surveillance selon la revendication 1,
dans lequel le premier moyen de détection (3) est configuré pour calculer la puissance électrique (4) alimentée à la machine électrique (2) en se basant sur une tension électrique (10) alimentée à la machine électrique (2) et un courant électrique (11) alimenté à la machine électrique (2).

3. Dispositif de surveillance selon la revendication 2,
dans lequel le premier moyen de détection (3) présente un capteur de tension (12) pour détecter la tension électrique (10) alimentée à la machine électrique (2) ; et/ou

dans lequel le premier moyen de détection (3) présente un capteur de courant (13) pour détecter le courant électrique alimenté à la machine électrique (2).

4. Dispositif de surveillance selon une des revendications 2 et 3, dans lequel le premier moyen de détection (3) présente une interface de données de mesure (14) et est configuré pour détecter, par le biais de l'interface de données de mesure (14), la tension électrique (10) alimentée à la machine électrique (2) et/ou le courant électrique (11) alimente à la machine électrique (2).

5. Dispositif de surveillance selon une des revendications précédentes,
dans lequel le second moyen de détection (5) est configuré pour calculer la puissance mécanique théorique (6) délivrée par la machine électrique (2) en se basant sur un couple de rotation de la machine électrique (2) et sur une vitesse de rotation (18) de la machine électrique (2) prédéfinie par la commutation.

6. Dispositif de surveillance selon une des revendications précédentes,
dans lequel le moyen de calcul (7) est configuré pour calculer le rendement (8) sur une durée prédéfinie (15) et pour émettre le signal d'erreur (9) lorsque le rendement (8) est supérieur à 1 sur toute la durée.

7. Dispositif de commande (16) pour une machine électrique (2), comportant :

un moyen électronique de commande (17), configuré pour commander la machine électrique (2) en se basant sur une vitesse de rotation (18) prédéfinie ; et
un dispositif de surveillance (1) selon une des revendications précédentes ;
dans lequel le moyen électronique de commande (17) est configuré pour mettre la machine électrique (2) hors tension et/ou hors courant lorsque le dispositif de surveillance (1) émet un signal d'erreur (9).

8. Dispositif de commande selon la revendication 7,
dans lequel le moyen électronique de commande (17) présente au moins un capteur de tension (12) pour détecter une tension électrique (10) fournie à la disposition de la machine électrique (2) et est configuré pour fournir au dispositif de surveillance (1) une valeur qui caractérise la tension électrique (10) ; et/ou
dans lequel le moyen électronique de commande (17) présente au moins un capteur de courant (13) pour détecter un courant électrique (11) fourni à la disposition de la machine électrique (2) et est configuré pour fournir au dispositif de surveillance (1) une valeur qui caractérise le courant électrique détecté (11).

9. Procédé pour surveiller une machine électrique (2), présentant :

la détection (S1) d'une puissance électrique (4) alimentée à la machine électrique (2) ;

**caractérisé par**
la détection (S2) d'une puissance mécanique théorique (6) fournie par la machine électrique (2) en se basant sur une commutation de la machine électrique (2) ;
le calcul (S3) d'un rendement (8) de la machine électrique (2) en se basant sur la puissance électrique détectée (4) et la puissance mécanique théorique détectée (6) ; et
l'émission (S4) d'un signal d'erreur (9), lorsque le rendement (8) calculé est supérieur à 1.

10. Procédé selon la revendication 9,
dans lequel la puissance électrique (4) alimentée à la machine électrique (2) est calculée en se basant sur une tension électrique (10) alimentée à la machine électrique (2) et un courant électrique (11) alimenté à la machine électrique (2).

11. Procédé selon la revendication 10,
dans lequel la tension électrique (10) alimentée à la machine électrique (2) est détectée par un capteur de tension (12) ; et/ou
dans lequel le courant électrique (11) alimenté à la machine électrique (2) est détecté par un capteur de courant (13).

12. Procédé selon la revendication 10 ou 11,
dans lequel la tension électrique (10) alimentée à la machine électrique (2) et/ou le courant électrique (11) alimenté à la machine électrique (2) est détecté par le biais d'une interface de données de mesure (14).

**13.** Procédé selon une des revendications 9 à 12,
dans lequel la puissance mécanique théorique (6) fournie par la machine électrique (2) est calculée en se basant sur un couple de rotation de la machine électrique (2) et une vitesse de rotation (18) de la machine électrique (2) prédéfinie par la commutation.

**14.** Procédé selon une des revendications 9 à 13,
dans lequel le rendement (8) est calculé sur une durée prédéfinie et le signal d'erreur (9) est émis lorsque le rendement (8) est supérieur à 1 sur toute la durée.

EP 2 998 753 B1

Fig. 1

Fig. 2

EP 2 998 753 B1

Fig. 3

Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2013184143 A1